# EUROPEAN PATENT APPLICATION

(11) **EP 4 729 963 A1**
(43) Date of publication of application: **22.04.2026**
(21) Application number: 25749141.5
(22) Date of filing: 22.01.2025
(51) Int. Cl.: G01R 31/3835, G01R 31/396, G01R 31/392, G01R 19/165, B60L 58/10

(54) **APPARATUS AND METHOD FOR DIAGNOSING BATTERY**

(30) Priority: 31.01.2024 KR 20240014924
(71) Applicant: LG Energy Solution, Ltd., Seoul 07335 (KR)
(72) Inventor: KWAK, Min, Daejeon 34122 (KR); SUN, Kyung-Eun, Daejeon 34122 (KR)
(74) Representative: Goddar, Heinz J.
(86) International application number: PCT/KR2025/001255
(87) International publication number: WO 2025/165054

(57) **Abstract**

Disclosed is an apparatus for diagnosing a battery, which includes a profile obtaining unit configured to obtain a differential profile representing a correspondence relationship between a differential capacity and a voltage of a battery; and a control unit configured to determine a target peak in the differential profile, calculate a first capacity and a second capacity of the differential profile based on the target peak, calculate a capacity ratio between the first capacity and the second capacity, and compare the calculated capacity ratio with a reference capacity ratio stored in advance to diagnose a state of the battery.

## Description

### TECHNICAL FIELD

This application is based on and claims priority from Korean Patent Application No. 10-2024-0014924, filed on January 31, 2024, with the Korean Intellectual Property Office, the disclosure of which is incorporated herein in its entirety by reference.

The present disclosure relates to an apparatus and method for diagnosing a battery, and more particularly, to an apparatus and method for diagnosing a battery, which diagnoses a state of the battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

A lot of research is being conducted on these batteries in terms of high-capacity and high-density, but the aspect of improving lifespan and safety is also important. In order to improve the safety of the battery, technology to accurately diagnose the current state of the battery is required.

### DISCLOSURE

### Technical Problem

The present disclosure is designed to solve the problems of the related art, and therefore the present disclosure is directed to providing an apparatus and method for diagnosing a battery, which diagnoses a state of the battery in a non-destructive manner.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

In one aspect of the present disclosure, there is provided an apparatus for diagnosing a battery, comprising: a profile obtaining unit configured to obtain a differential profile representing a correspondence relationship between a differential capacity and a voltage of a battery; and a control unit configured to determine a target peak in the differential profile, calculate a first capacity and a second capacity of the differential profile based on the target peak, calculate a capacity ratio between the first capacity and the second capacity, and compare the calculated capacity ratio with a reference capacity ratio stored in advance to diagnose a state of the battery.

The control unit may be configured to determine a peak with a largest differential capacity among a plurality of peaks included in the differential profile as the target peak.

The control unit may be configured to calculate the first capacity by computing a capacity of a low-voltage section based on the target peak and calculate the second capacity by computing a capacity of a high-voltage section based on the target peak.

The control unit may be configured to calculate the capacity ratio by dividing the second capacity by the first capacity.

The control unit may be configured to diagnose the state of the battery as a normal state when a capacity ratio difference between the capacity ratio and the reference capacity ratio is less than or equal to a preset threshold value.

The control unit may be configured to diagnose the state of the battery as an abnormal state when the capacity ratio difference exceeds the threshold value.

The profile obtaining unit may be configured to obtain a differential profile corresponding to each of a plurality of batteries.

The control unit may be configured to calculate a capacity ratio of each of the differential profiles for each of the plurality of batteries, compare each of the plurality of calculated capacity ratios with a reference capacity ratio preset for each of the plurality of batteries, and diagnose a relative state of the plurality of batteries based on the comparison result.

The control unit may be configured to diagnose that a degree of degradation is higher as a capacity ratio difference between the capacity ratio and the reference capacity ratio for the plurality of batteries is greater.

In another aspect of the present disclosure, there is provided a battery pack comprising the apparatus for diagnosing a battery according to an embodiment of the present disclosure.

In still another aspect of the present disclosure, there is provided a vehicle comprising the apparatus for diagnosing a battery according to an embodiment of the present disclosure.

In still another aspect of the present disclosure, there is provided a method for diagnosing a battery, comprising: a profile obtaining step of obtaining a differential profile representing a correspondence relationship between a differential capacity and a voltage of a battery; a target peak determining step of determining a target peak in the differential profile; a capacity calculating step of calculating a first capacity and a second capacity of the differential profile based on the target peak; a capacity ratio calculating step of calculating a capacity ratio between the first capacity and the second capacity; and a diagnosing step of comparing the calculated capacity ratio with a reference capacity ratio stored in advance to diagnose a state of the battery.

### Advantageous Effects

According to one aspect of the present disclosure, the apparatus for diagnosing a battery has an advantage of non-destructively diagnosing the state of a battery based on a capacity ratio obtained from a differential profile of the battery.

In addition, according to one aspect of the present disclosure, the apparatus for diagnosing a battery has an advantage of diagnosing the state of the battery based on the overall shape of the differential profile.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for diagnosing a battery according to an embodiment of the present disclosure.
FIG. 2 is a diagram schematically showing a differential profile according to an embodiment of the present disclosure.
FIG. 3 is a schematic diagram showing a plurality of differential profiles according to an embodiment of the present disclosure.
FIG. 4 is a schematic diagram showing a capacity ratio of a plurality of batteries according to an embodiment of the present disclosure.
FIG. 5 is a diagram schematically showing a battery pack according to another embodiment of the present disclosure.
FIG. 6 is a diagram schematically showing a vehicle according to still another embodiment of the present disclosure.
FIG. 7 is a diagram for schematically illustrating a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

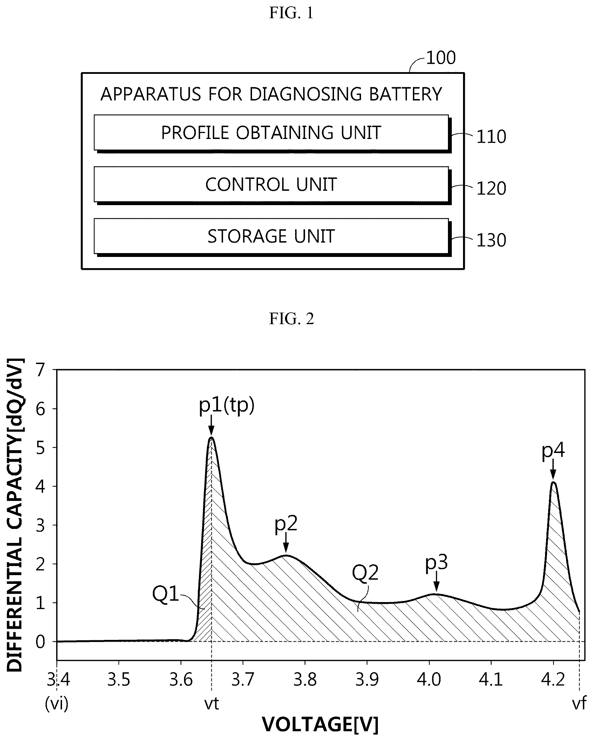

FIG. 1 is a diagram schematically showing an apparatus 100 for diagnosing a battery according to an embodiment of the present disclosure.

Referring to FIG. 1, the apparatus 100 for diagnosing a battery may include a profile obtaining unit 110 and a control unit 120.

Here, the battery refers to an independent cell that has a negative terminal and a positive terminal and is physically separable. As an example, a lithium-ion battery or a lithium polymer battery may be considered as a battery. Additionally, the type of battery may be a cylindrical type, a prismatic type, or a pouch type. Additionally, the battery may mean a battery bank, a battery module or a battery pack in which a plurality of cells are connected in series and/or parallel. Below, for convenience of explanation, the battery is explained as meaning one independent cell.

The profile obtaining unit 110 may be configured to obtain a differential profile representing a correspondence relationship between a differential capacity and a voltage of the battery.

For example, the battery profile is a profile representing a correspondence relationship between voltage (V) and capacity (Q) when the SOC of the battery is charged from a preset charge start SOC or 0% to a preset charge end SOC or 100%. As another example, the battery profile may represent a correspondence relationship between voltage (V) and capacity (Q) when the SOC of the battery is discharged from a preset discharge start SOC or 100% to a preset discharge end SOC or 0%.

In addition, if the battery profile is differentiated with respect to voltage, a differential profile representing the correspondence relationship between the differential capacity (dQ/dV) and the voltage (V) may be generated.

For example, there is no special limitation on the C-rate in the charge or discharge for generating the battery profile. However, preferably, the battery should be charged or discharged at a low rate in order to obtain a more accurate battery profile and differential profile. For example, the battery profile may be generated in the process of charging or discharging the battery at 0.05C.

For example, the profile obtaining unit 110 may directly receive the differential profile of the battery from the outside. That is, the profile obtaining unit 110 may be connected to the outside by wire and/or wirelessly and receive the differential profile to obtain the differential profile.

As another example, the profile obtaining unit 110 may directly receive the battery profile of the battery from the outside. Also, the profile obtaining unit 110 may differentiate the battery profile with respect to the voltage to generate a differential profile. That is, the profile obtaining unit 110 may be connected to the outside by wire and/or wirelessly to obtain the profile, and directly generate a differential profile from the battery profile to obtain the differential profile.

As still another example, the profile obtaining unit 110 may receive battery information about the voltage and capacity of the battery. Also, the profile obtaining unit 110 may generate a battery profile based on the received battery information, and generate a differential profile based on the generated battery profile. That is, the profile obtaining unit 110 may obtain a differential profile by directly generating the differential profile based on the battery information.

FIG. 2 is a diagram schematically showing a differential profile P according to an embodiment of the present disclosure. For example, the differential profile P may be represented as an X-Y graph where the X-axis is set to voltage and the Y-axis is set to differential capacity.

The profile obtaining unit 110 may be connected to communicate with the control unit 120. For example, the profile obtaining unit 110 may be connected to the control unit 120 by wire and/or wirelessly. The profile obtaining unit may transmit the obtained differential profile to the control unit 120.

The control unit 120 may be configured to determine a target peak tp from the differential profile P.

Specifically, the differential profile P may include a plurality of peaks p1, p2, p3, p4. Here, a peak is a local maximum of the differential profile P, which is a point where the instantaneous rate of change of the differential capacity with respect to the voltage is 0. The control unit 120 may determine one of the plurality of peaks p1, p2, p3, p4 included in the differential profile P as the target peak tp based on the voltage or the differential capacity.

Preferably, the control unit 120 may be configured to determine a peak having the largest differential capacity among the plurality of peaks p1, p2, p3, p4 included in the differential profile P as the target peak tp.

For example, in the embodiment of FIG. 2, the differential profile P may include a first peak p1, a second peak p2, a third peak p3, and a fourth peak p4. Since the differential capacity of the first peak p1 is largest among the first to fourth peaks p1, p2, p3, p4, the control unit 120 may determine the first peak p1 as the target peak tp.

The control unit 120 may be configured to calculate a first capacity Q1 and a second capacity Q2 of the differential profile P based on the target peak tp.

Specifically, the control unit 120 may be configured to calculate the capacity of a low-voltage section based on the target peak tp to calculate a first capacity Q1, and to calculate the capacity of a high-voltage section based on the target peak tp to calculate a second capacity Q2.

For example, the control unit 120 may calculate the capacity from a charge start voltage of the battery to the voltage of the target peak tp as the first capacity Q1, and may calculate the capacity from the voltage of the target peak tp to a charge end voltage of the battery as the second capacity Q2.

In the embodiment of FIG. 2, it is assumed that the charge start voltage of the battery is vi [V], the voltage of the target peak tp is vt [V], and the charge end voltage of the battery is vf [V]. The control unit 120 may calculate the first capacity Q1 for the voltage range of vi [V] to vt [V]. Specifically, the control unit 120 may calculate the first capacity Q1 by integrating the differential profile P with respect to voltage in the voltage range of vi [V] to vt [V]. Also, the control unit 120 may calculate the second capacity Q2 for the voltage range of vt [V] to vf [V]. Specifically, the control unit 120 may calculate the second capacity Q2 by integrating the differential profile P with respect to voltage in the voltage range of vt [V] to vf [V].

The control unit 120 may be configured to calculate a capacity ratio between the first capacity Q1 and the second capacity Q2.

Generally, the state of the positive electrode of the battery is mainly reflected in the high-voltage section, and the state of the negative electrode of the battery is mainly reflected in the low-voltage section. This is because the negative electrode of the battery includes a negative electrode flat section in which the voltage change amount of the negative electrode becomes smaller as the capacity of the battery increases (i.e., as the voltage of the battery increases). Therefore, the control unit 120 may calculate the capacity ratio between the first capacity Q1 and the second capacity Q2 in order to diagnose the state of the battery caused by the positive electrode.

Specifically, the control unit 120 may calculate the capacity ratio by computing the ratio of the second capacity Q2 to the first capacity Q1. For example, the control unit 120 may be configured to calculate the capacity ratio by dividing the second capacity Q2 by the first capacity Q1. That is, the control unit 120 may calculate the capacity ratio by computing the formula "first capacity Q1 ÷ second capacity Q2".

The control unit 120 may be configured to diagnose the state of the battery by comparing the calculated capacity ratio with a reference capacity ratio stored in advance.

Here, the reference capacity ratio is a capacity ratio of a reference differential profile, and may be preset to correspond to the battery. For example, the reference capacity ratio may be a capacity ratio of a battery in the BOL (Beginning Of Life) state, a capacity ratio in a previous cycle of the battery, a capacity ratio of a reference battery designed to correspond to the battery, or a theoretically designed capacity ratio.

The control unit 120 may calculate the capacity ratio difference between the calculated capacity ratio and a preset reference capacity ratio. Also, the control unit 120 may compare the calculated capacity ratio difference with a preset threshold value. Also, the control unit 120 may diagnose the state of the battery based on the result of the comparison.

For example, the control unit 120 may be configured to diagnose the state of the battery as a normal state if the capacity ratio difference between the capacity ratio and the reference capacity ratio is less than or equal to the preset threshold value. That is, the control unit 120 may diagnose the state of the battery as a normal state if the difference between the calculated capacity ratio and the reference capacity ratio is less than or equal to the threshold value.

As another example, the control unit 120 may be configured to diagnose the state of the battery as an abnormal state if the capacity ratio difference exceeds the threshold value. That is, the control unit 120 may diagnose the state of the battery as an abnormal state if the difference between the calculated capacity ratio and the reference capacity ratio exceeds the threshold value.

Specifically, if the capacity ratio between the first capacity Q1 and the second capacity Q2 of the differential profile P significantly changes compared to the reference capacity ratio, the difference between the capacity ratio of the differential profile P and the reference capacity ratio may exceed the threshold value. That is, if the state of the battery is diagnosed as an abnormal state, it may be regarded that the shape of the differential profile P is significantly changed from the shape of the reference differential profile. Furthermore, since the capacity ratio is a factor indicating the state of the positive electrode, it may be regarded that the current state of the positive electrode of the battery is significantly degraded compared to the state of the positive electrode corresponding to the reference differential profile.

The apparatus for diagnosing a battery 100 according to an embodiment of the present disclosure has an advantage of non-destructively diagnosing the state of a battery based on a capacity ratio obtained from the differential profile P of the battery.

Moreover, the apparatus for diagnosing a battery 100 has an advantage of diagnosing the state of the battery based on the overall shape of the differential profile P. That is, the apparatus for diagnosing a battery 100 may diagnose the state of the battery by considering the overall shape of the differential profile P, rather than diagnosing the state of the battery only based on factors related to peaks, such as the number of peaks, differential capacity and voltage, or voltage difference between peaks. Accordingly, since the apparatus for diagnosing a battery 100 may diagnose the state of a battery by considering the differential profile P as a whole, the state of the battery may be diagnosed more accurately compared to the case where the state of the battery is diagnosed only by a specific peak.

Meanwhile, the profile obtaining unit 110 and the control unit 120 included in the apparatus 100 for diagnosing a battery optionally include a processor, an application-specific integrated circuit (ASIC), other chipset, a logic circuit, a register, a communication modem, a data processing device, etc. known in the art to execute various control logics performed in the present disclosure. Also, when the control logic is implemented as software, the profile obtaining unit 110 and the control unit 120 may be implemented as a set of program modules. At this time, the program module may be stored in the memory and executed by the profile obtaining unit 110 and the control unit 120.

In addition, the apparatus 100 for diagnosing a battery may further include a storage unit 130. The storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the profile obtaining unit 110 and the control unit 120 are defined.

For example, the storage unit 130 may store data used to diagnose the state of a battery, such as the differential profile, the reference differential profile, and the reference capacity ratio.

The profile obtaining unit 110 may be configured to obtain a differential profile corresponding to each of a plurality of batteries.

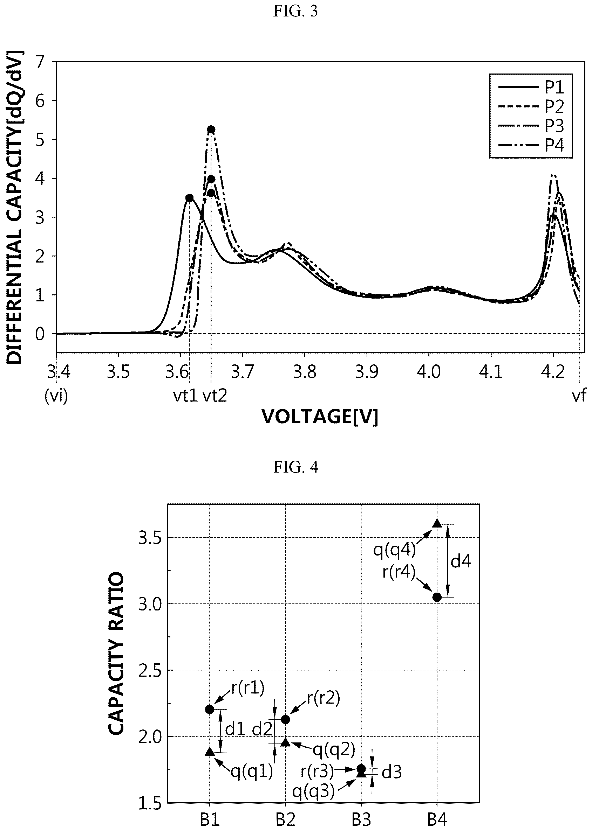

FIG. 3 is a schematic diagram showing a plurality of differential profiles P1, P2, P3, P4 according to an embodiment of the present disclosure.

For example, in the embodiment of FIG. 3, the profile obtaining unit 110 may obtain a first differential profile P1 of the first battery, a second differential profile P2 of the second battery, a third differential profile P3 of the third battery, and a fourth differential profile P4 of the fourth battery.

The control unit 120 may be configured to calculate a capacity ratio for each of the differential profiles of the plurality of batteries.

First, the control unit 120 may determine a target peak of each of the plurality of differential profiles P1, P2, P3, P4. In the embodiment of FIG. 3, the control unit 120 may determine the target peak of the first differential profile P1 as a peak corresponding to vt1 [V], and determine the target peak of the second to fourth differential profiles P2, P3, P4 as a peak corresponding to vt2 [V].

Next, the control unit 120 may calculate the capacity ratio of each of the plurality of differential profiles P1, P2, P3, P4. In the embodiment of FIG. 3, the control unit 120 may calculate the capacity ratio of each of the first differential profile P1, the second differential profile P2, the third differential profile P3, and the fourth differential profile P4. Specifically, the control unit 120 may calculate the first capacity ratio q1 of the first differential profile P1, calculate the second capacity ratio q2 of the second differential profile P2, calculate the third capacity ratio q3 of the third differential profile P3, and calculate the fourth capacity ratio q4 of the fourth differential profile P4.

The control unit 120 may be configured to compare each of the plurality of generated capacity ratios with a reference capacity ratio preset for each of the plurality of batteries.

Specifically, the reference capacity ratio is a capacity ratio determined from the reference differential profile. Also, since the reference differential profile is independently preset for each battery, the reference capacity ratio may also be preset for each battery. Therefore, the control unit 120 may compare the corresponding capacity ratio with the reference capacity ratio.

FIG. 4 is a schematic diagram showing a capacity ratio q of a plurality of batteries according to an embodiment of the present disclosure. Specifically, the embodiment of FIG. 4 is a diagram showing the reference capacity ratio r and the calculated capacity ratio q of the first to fourth batteries B1, B2, B3, B4.

For example, in the embodiment of FIG. 4, the control unit 120 may calculate a first capacity ratio q1 difference between the first reference capacity ratio r1 of the first battery B1 and the calculated first capacity ratio q1. Also, the control unit 120 may calculate a second capacity ratio q2 difference between the second reference capacity ratio r2 of the second battery B2 and the calculated second capacity ratio q2. Also, the control unit 120 may calculate a third capacity ratio q3 difference between the third reference capacity ratio r3 of the third battery B3 and the calculated third capacity ratio q3. Also, the control unit 120 may calculate a fourth capacity ratio q4 difference between the fourth reference capacity ratio r4 of the fourth battery B4 and the calculated fourth capacity ratio q4.

The control unit 120 may be configured to diagnose the relative state between a plurality of batteries B1, B2, B3, B4 based on the comparison result.

Specifically, the control unit 120 may directly compare the magnitudes of the plurality of calculated capacity ratio differences. In addition, the control unit 120 may be configured to diagnose that the degree of degradation is higher as the capacity ratio difference between the capacity ratio and the reference capacity ratio is larger for the plurality of batteries B1, B2, B3, B4.

For example, in the embodiment of FIG. 4, when comparing the magnitudes of the differences of the first to fourth capacity ratios q1, q2, q3, q4, the magnitudes of the calculated capacity ratio differences are in the order of the fourth capacity ratio q4 difference, the first capacity ratio q1 difference, the second capacity ratio q2 difference, and the third capacity ratio q3 difference. That is, the fourth capacity ratio q4 difference is largest, the third capacity ratio q3 difference is smallest, and the first capacity ratio q1 difference is larger than the second capacity ratio q2 difference.

Therefore, the control unit 120 may diagnose that the degree of degradation is higher in the order of the fourth battery B4, the first battery B1, the second battery B2, and the third battery B3. In other words, the control unit 120 may diagnose that the fourth battery B4 is degraded most, and the third battery B3 is degraded least. In addition, the control unit 120 may diagnose that the first battery B1 is degraded more than the second battery B2.

The apparatus for diagnosing a battery 100 according to an embodiment of the present disclosure has an advantage of diagnosing the relative degree of degradation between a plurality of batteries based on the differential profile of the plurality of batteries.

The apparatus 100 for diagnosing a battery according to the present disclosure can be applied to the BMS. In other words, the BMS according to the present disclosure may include the above-described apparatus 100 for diagnosing a battery. In this configuration, at least some of the components of the apparatus 100 for diagnosing a battery may be implemented by supplementing or adding functions of components included in a conventional BMS. For example, the profile obtaining unit 110, the control unit 120 and the storage unit 130 of the apparatus 100 for diagnosing a battery may be implemented as components of a BMS.

Additionally, the apparatus 100 for diagnosing a battery according to the present disclosure may be provided in the battery pack. That is, the battery pack according to the present disclosure may include the above-described apparatus 100 for diagnosing a battery and at least one battery cell. Additionally, the battery pack may further include electrical components (relays, fuses, etc.) and a case.

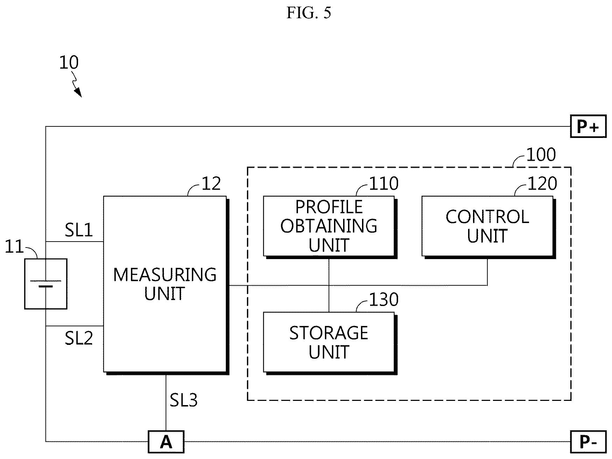

FIG. 5 is a diagram schematically showing a battery pack including according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to a first sensing line SL1, a second sensing line SL2, and a third sensing line SL3. Specifically, the measuring unit 12 may be connected to the positive electrode terminal of the battery 11 through the first sensing line SL1, and connected to the negative electrode terminal of the battery 11 through the second sensing line SL2. The measuring unit 12 may measure the voltage of the battery 11 based on the voltage measured at each of the first sensing line SL1 and the second sensing line SL2.

In addition, the measuring unit 12 can be connected to a current measurement unit A through the third sensing line SL3. For example, the current measurement unit A may be an ammeter or shunt resistor that can measure the charging current and discharging current of the battery 11. The measuring unit 12 may calculate the charging amount by measuring the charging current of the battery 11 through the third sensing line SL3. Additionally, the measuring unit 12 can calculate the discharge amount by measuring the discharge current of the battery 11 through the third sensing line SL3.

For example, the profile obtaining unit 110 may receive battery information about the voltage and current of the battery from the measuring unit 12. Then, the profile obtaining unit 110 may generate a battery profile and a differential profile based on the battery information.

As another example, the profile obtaining unit 110 may receive a battery profile from the measuring unit 12. Then, the profile obtaining unit 110 may generate a differential profile based on the battery profile.

As still another example, the profile obtaining unit 110 may receive a differential profile from the measuring unit 12.

An external device may be connected to the positive electrode terminal P+ and the negative electrode terminal P- of the battery pack 10. For example, the external device may be a charging device or a load. In addition, the positive electrode terminal of the battery 11, the positive electrode terminal P+ of the battery pack 10, the external device, the negative electrode terminal P- of the battery pack 10, and the negative electrode terminal of the battery 11 may be electrically connected.

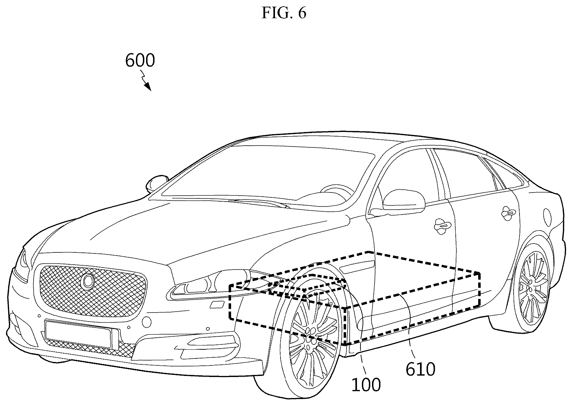

FIG. 6 is a diagram schematically showing a vehicle 600 according to still another embodiment of the present disclosure.

Referring to FIG. 6, the battery pack 610 according to an embodiment of the present disclosure may be included in a vehicle 600 such as an electric vehicle (EV) or a hybrid vehicle (HV). In addition, the battery pack 610 may drive the vehicle 600 by supplying power to a motor through an inverter included in the vehicle 600. Here, the battery pack 610 may include the apparatus 100 for diagnosing a battery. That is, the vehicle 600 may include the apparatus 100 for diagnosing a battery. In this case, the apparatus 100 for diagnosing a battery may be an on-board device included in the vehicle 600.

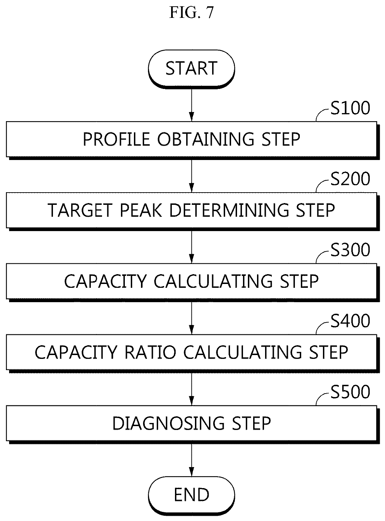

FIG. 7 is a diagram for schematically illustrating a method for diagnosing a battery according to still another embodiment of the present disclosure.

Referring to FIG. 7, the method for diagnosing a battery may include a profile obtaining step (S100), a target peak determining step (S200), a capacity calculating step (S300), a capacity ratio calculating step (S400) and a diagnosing step (S500).

Preferably, each step of the method for diagnosing a battery can be performed by the apparatus 100 for diagnosing a battery. Hereinafter, for convenience of explanation, content that overlaps with the content described above will be omitted or briefly described.

The profile obtaining step (S100) is a step of obtaining a differential profile representing a correspondence relationship between a differential capacity and a voltage of a battery, and may be performed by the profile obtaining unit 110.

For example, the profile obtaining unit 110 may directly receive the differential profile of the battery from the outside. That is, the profile obtaining unit 110 may be connected to the outside by wire and/or wirelessly and receive the differential profile to obtain the differential profile.

As another example, the profile obtaining unit 110 may directly receive the battery profile of the battery from the outside. Also, the profile obtaining unit 110 may differentiate the battery profile with respect to the voltage to generate a differential profile. That is, the profile obtaining unit 110 may be connected to the outside by wire and/or wirelessly to obtain the profile, and directly generate a differential profile from the battery profile to obtain the differential profile.

As still another example, the profile obtaining unit 110 may receive battery information about the voltage and capacity of the battery. Also, the profile obtaining unit 110 may generate a battery profile based on the received battery information, and generate a differential profile based on the generated battery profile. That is, the profile obtaining unit 110 may obtain a differential profile by directly generating the differential profile based on the battery information.

The target peak determining step (S200) is a step of determining a target peak tp in the differential profile, and may be performed by the control unit 120.

For example, in the embodiment of FIG. 2, the control unit 120 may be configured to determine the first peak p1 having the largest differential capacity among the plurality of peaks p1, p2, p3, p4 included in the differential profile P as the target peak tp.

The capacity calculating step (S300) is a step of calculating a first capacity Q1 and a second capacity Q2 of the differential profile P based on the target peak tp, and may be performed by the control unit 120.

For example, the control unit 120 may be configured to calculate the capacity of a low-voltage section based on the target peak tp to calculate a first capacity Q1, and to calculate the capacity of a high-voltage section based on the target peak tp to calculate a second capacity Q2.

The capacity ratio calculating step (S400) is a step of calculating a capacity ratio between the first capacity Q1 and the second capacity Q2, and may be performed by the control unit 120.

Specifically, the control unit 120 may calculate the capacity ratio by computing the ratio of the second capacity Q2 to the first capacity Q1. For example, the control unit 120 may be configured to calculate the capacity ratio by dividing the second capacity Q2 by the first capacity Q1.

The diagnosing step (S500) is a step for diagnosing the state of the battery by comparing the calculated capacity ratio with a reference capacity ratio stored in advance, and may be performed by the control unit 120.

For example, control unit 120 may be configured to diagnose the state of the battery as a normal state if the capacity ratio difference between the capacity ratio and the reference capacity ratio is less than a preset threshold value.

As another example, the control unit 120 may be configured to diagnose the state of the battery as an abnormal state if the capacity ratio difference exceeds the threshold value.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Reference Signs)

10: battery pack
11: battery
12: measuring unit
100: apparatus for diagnosing a battery
110: profile obtaining unit
120: control unit
130: storage unit
600: vehicle
610: battery pack

## Claims

1. An apparatus for diagnosing a battery, comprising:
a profile obtaining unit configured to obtain a differential profile representing a correspondence relationship between a differential capacity and a voltage of a battery; and
a control unit configured to determine a target peak in the differential profile, calculate a first capacity and a second capacity of the differential profile based on the target peak, calculate a capacity ratio between the first capacity and the second capacity, and compare the calculated capacity ratio with a reference capacity ratio stored in advance to diagnose a state of the battery.

2. The apparatus for diagnosing a battery according to claim 1,
wherein the control unit is configured to determine a peak with a largest differential capacity among a plurality of peaks included in the differential profile as the target peak.

3. The apparatus for diagnosing a battery according to claim 1,
wherein the control unit is configured to calculate the first capacity by computing a capacity of a low-voltage section based on the target peak and calculate the second capacity by computing a capacity of a high-voltage section based on the target peak.

4. The apparatus for diagnosing a battery according to claim 1,
wherein the control unit is configured to calculate the capacity ratio by dividing the second capacity by the first capacity.

5. The apparatus for diagnosing a battery according to claim 1,
wherein the control unit is configured to diagnose the state of the battery as a normal state when a capacity ratio difference between the capacity ratio and the reference capacity ratio is less than or equal to a preset threshold value, and
wherein the control unit is configured to diagnose the state of the battery as an abnormal state when the capacity ratio difference exceeds the threshold value.

6. The apparatus for diagnosing a battery according to claim 1,
wherein the profile obtaining unit is configured to obtain a differential profile corresponding to each of a plurality of batteries, and
wherein the control unit is configured to calculate a capacity ratio of each of the differential profiles for each of the plurality of batteries, compare each of the plurality of calculated capacity ratios with a reference capacity ratio preset for each of the plurality of batteries, and diagnose a relative state of the plurality of batteries based on the comparison result.

7. The apparatus for diagnosing a battery according to claim 6,
wherein the control unit is configured to diagnose that a degree of degradation is higher as a capacity ratio difference between the capacity ratio and the reference capacity ratio for the plurality of batteries is greater.

8. A battery pack comprising the apparatus for diagnosing a battery according to any one of claims 1 to 7.

9. A vehicle comprising the apparatus for diagnosing a battery according to any one of claims 1 to 7.

10. A method for diagnosing a battery, comprising:
a profile obtaining step of obtaining a differential profile representing a correspondence relationship between a differential capacity and a voltage of a battery;
a target peak determining step of determining a target peak in the differential profile;
a capacity calculating step of calculating a first capacity and a second capacity of the differential profile based on the target peak;
a capacity ratio calculating step of calculating a capacity ratio between the first capacity and the second capacity; and
a diagnosing step of comparing the calculated capacity ratio with a reference capacity ratio stored in advance to diagnose a state of the battery.
